# EUROPEAN PATENT SPECIFICATION

(11) **EP 0 929 999 B1**
(45) Date of publication and mention of the grant of the patent: **03.03.2004**
(21) Application number: 97942063.5
(22) Date of filing: 26.09.1997
(51) Int. Cl.: H05K 9/00

(54) **A PROTECTIVE DEVICE FOR SHIELDING AN ELECTRICAL APPARATUS AGAINST ENVIRONMENTAL CONDITIONS**
SCHUTZVORRICHTUNG ZUR ABSCHIRMUNG VON EINEM ELEKTRISCHEN GERÄT UNTER UMWELTBEDINGUNGEN
APPAREIL DE PROTECTION PERMETTANT DE BLINDER UN APPAREIL ELECTRIQUE CONTRE DES CONDITIONS ENVIRONNEMENTALES

(30) Priority: 27.09.1996 FI 963872
(43) Date of publication of application: 21.07.1999
(73) Proprietor: Ruuttu, Jari, 10330 Billnäs (FI); Törnroos, Filip, 20700 Turku (FI)
(72) Inventor: Ruuttu, Jari, 10330 Billnäs (FI); Törnroos, Filip, 20700 Turku (FI)
(74) Representative: Brax, Matti Juhani
(86) International application number: PCT/FI1997/000579
(87) International publication number: WO 1998/014040

(56) References cited:
- WO-A-95/34423
- US-A- 3 436 467
- US-A- 3 756 399
- US-A- 4 227 037
- US-A- 4 639 545
- US-A- 4 959 752
- US-A- 5 318 855
- US-A- 5 392 197
- US-A- 5 436 803
- US-A- 5 519 585

## Description

The invention relates in general to a protective device for shielding an electrical apparatus against moisture, dirt, dust, electromagnetic interference, unauthorised access, etc. In particular the invention relates to such protective device wherein protection is implemented at the printed circuit board or corresponding component part level, see for example WO-A-9 534 423 and US-A-3 436 467.

Protecting electrical apparatus particularly against moisture is a common problem. At the same time it is often necessary to protect the apparatus against dirt and dust. In many cases it is also desirable that the protective means is tight and continuous enough so as to prevent unauthorised access to functional parts of the electrical apparatus. The latter is especially important when thinking of a situation where the apparatus is brought to be repaired under warranty and one has to determine whether the fault to be repaired was caused by tampering. At the same time that the operating frequencies of electronic apparatus get higher and higher and their sensitivity increases and consumer devices, such as mobile phones, that operate at radio frequencies, become more and more widespread, electromagnetic compatibility (EMC) has become an important factor. Sensitive circuits have to be shielded against electromagnetic radiation coming from outside the apparatus or from other parts of the apparatus itself On the other hand, high-frequency circuits should be enclosed within a shield in order to minimise the electromagnetic interference load caused by them. Such electromagnetic shielding is generally called EMC shielding.

Tight and continuous protection is made more difficult by the fact that an electrical apparatus must interact with its environment. Various displays, indicator lights, LEDs, pointers, infrared communications ports and other similar parts require that at these locations the shielding is open or at least transparent at a certain frequency of electromagnetic radiation. Connectors based on galvanic contact require some kind of lead-through in the shielding. A connection between the shielded apparatus and another part may require both mechanical and electric coupling; consider, for example, the interface of a mobile phone and its battery. Another factor to be taken into account in the implementation of the shielding is often the requirement that the apparatus should be small and lightweight so that the shielding arrangement must not be space-consuming or heavy. If the apparatus shielded is so valuable that it is sensible to repair it when it fails, the shielding shall not be so strong that it is impossible to open it without damaging the apparatus.

When shielding an electrical apparatus one has to decide whether to realise the shielding at the level of the outer shell enclosing the whole apparatus or to shield the printed circuit boards and other parts inside the apparatus separately and independently. In addition to solutions representing both extremities it is known various combinations of them. Of these two alternatives the present invention is more related to the shielding at the printed circuit board level even though not limited to it, so, below it will be disclosed a few prior-art solutions for shielding printed circuit boards and corresponding component parts. In the description to follow the element to be shielded is simply called a printed circuit board.

Two basic approaches are known from the prior art and the first of them involves coating of the printed circuit board with varnish, plastic compound or another conformal and curable material. The layer formed against the surface of the printed circuit board must be insulative lest it cause short circuits between the different parts of the printed circuit board. It may further be coated by a layer containing metal or conductive polymer, thus providing EMC shielding. A construction is known e.g. from document DE 40 16 953 wherein a printed circuit board is first coated with an insulative compound and then with a conductive compound. The insulating layer also encloses the printed circuit board's external wire connections. In a method according to document DE 29 51 063 a printed circuit board is first coated with a plastic compound and before said compound hardens a powdery filler is added on top of said compound and, when subjected to a heat treatment, said powdery filler hardens together with said plastic compound. Conductive polymer compounds suitable for such shielding are known e.g. from documents EP 348 794, GB 2 150 143, DE 26 49 267, EP 347 597, DE 39 36 534, DE 39 36 511, DE 39 36 494 and DE 36 13 060. Document US 5 147 694 discloses the protection of transparent windows against penetration by electromagnetic radiation. In document US 5 166 864 a dielectric polymer layer is formed directly on a printed circuit board so that by means of masking, certain areas are left uncoated. A metallic coating is formed on top of the polymer layer with the purpose of both shielding against electromagnetic interference (EMI) and providing grounding and heat conduction paths.

The second basic approach is to manufacture, by means of laminating or another suitable method, a film, sleeve or bag which is spread on a printed circuit board. So, in this case the protective device is more or less a prefabricated object before attachment to the printed circuit board, and it is not applied onto the printed circuit board from a container of liquid or compound like in the solutions according to the first basic approach. If the material of the film, sleeve or bag is thermoformable, its setting on the printed circuit board can be improved by means of heat treatment, in which case the boundary between said approaches somewhat blurs. For example, document US 5 407 865 discloses a protective film consisting of an insulating polymer and a metal layer added to it by means of laminating, sputtering or another method. Part of the polymer layer is removed at the edge of the protective film so that the film can be attached by its metal part to the metal rim of the apparatus protected. Attachment is carried out metallurgically and the film sets flexibly on the apparatus protected. In document WO 95/28822 an insulative layer set on the surface of a printed circuit board and its components consists of two plastics having different thermoforming points. In addition, the two-layer structure is coated by a conductive layer. In document US 5 260 128 the effect of an electromagnetic shielding sheet is based on flakes made from an amorphous, soft metal alloy, said flakes constituting a layer in a laminated structure. Document EP 352 729 discloses that a metal layer in an EMI shielding shrink film can be corrugated so that it will not tear so easily when shrunk. In document SE 462 944 a printed circuit board is inserted in a bag and the air is sucked out so that the pressure of the air outside the bag sets the bag tightly against the surface of the printed circuit board. An electrically conductive layer of varnish is spread on the surface of the bag.

Document US 3 436 467 (R.S. Smith, Jr.) discloses a shielding cover comprising an upper part and a lower part. An object to be shielded or a mould imitating said object is covered by a film made of cellulose acetate or cellulose propionate or corresponding insulative material which is vacuum formed over said object or mould. A thin metal foil is hand formed over said film and an insulative layer is again vacuum formed over said foil. The upper and lower parts thus manufactured are joined together by hot sealing or a cement. In document US 5 392 197 (Cuntz et al.) a plastic "hood" is glued or soldered on the upper or lower surface of a printed circuit board, said hood remaining inside the mechanical housing of the apparatus and the purpose of said hood being protection of the apparatus against moisture. The hood does not extend to the edges of the printed circuit board but it has to be smaller than the printed circuit board for the gluing to be successful. PCT document WO 95/34423 discloses a shielding case the surface of which has a portion comprising three separate foils: The shielding case is formed in injection moulding where the foils are laminated and become the outer surface of the injection moulded object and the injection moulding plastic provides the structure with the necessary mechanical rigidity. Document US 4 959 752 (Samarov et al.) discloses an embodiment in which a shield for an electrical apparatus is made from a preformed film. It is coated with a metal layer by means of a method not unlike galvanising or spraying. A very similar arrangement is disclosed in document US 5 519 585 wherein a printed circuit board in a portable computer is protected by a preformed, metallised shield.

The prior-art protection arrangements described above have a number of disadvantages. If the printed circuit board is cast or dipped in a fluid, viscous or paste-like material such as an epoxy resin, the protective layer sets quite tightly over the minutest details of the printed circuit board and sticks to the board because of the adhesion between the materials. If a fault in the printed circuit board then requires a contact between a portion of the board and an instrument or the replacement of a component, the protective material has to be removed, at least partially, which may be very difficult. Also in the arrangements. in which a pre-laminated protective layer by means of heat treatment or other process sets tightly over the printed circuit board, controlled removal of the protective layer without damaging the components may be difficult. Further, it is problematic to form the holes or transparent areas mentioned earlier on, and in prior-art solutions that may be difficult or impossible without compromising the tightness of the shield. It is also typical of the prior-art arrangements that printed circuit boards have to be handled individually. If the shielding process requires that the printed circuit boards be moved to special racks for dipping, bagging, varnishing and/or other manufacturing steps, it will be difficult to automate the process, which increases manufacturing costs.

The solutions described above have yet another disadvantage related to the risk of an electrical breakdown and capacitive couplings between the inner parts of the components and the grounded EMC shield. If, in accordance with the prior art, an electrically conductive shield, made of metal or conductive polymer, is (as part of an overall protective structure) varnished, vaporised, thermoformed or vacuum formed tightly over the components of a printed circuit board (apart from a thin insulative intermediate layer), it may cause an electrical breakdown, i.e. a phenomenon where the current at a component is in an uncontrolled manner discharged through the intermediate insulative layers to the grounded shield. The consequences of a breakdown are usually devastating and in order to prevent it, there are regulations stating the minimum distances between high-voltage components and the nearest other conductive material. A capacitive coupling may occur if a high-frequency signal travels in a circuit. The conductor in the circuit and the shield near to its outer surface constitute a capacitor which affects the behaviour of the signals in the circuit and considerably impedes the intended operation of the circuit.

Next it will considered some prior-art arrangements for realising EMC protection. The basic idea in these implementations is to shield a component or group of components by a protective cover attached over said component(s). Patent document US 4 754 101 discloses a frame made of a thin plate having several attachment pins on the lower edge at regular intervals and several deflectable engagement prongs on the upper edge. The attachment pins are soldered to holes in the printed circuit board and the EMC shield proper is pushed against the engagement prongs so that the spring force of the prongs holds the cover securely in its place. Patent document US 4 890 199 discloses a similar arrangement wherein the attachment frame comprises springs bent such that they have a U-shaped cross section, the bottom side of the U being soldered to a printed circuit board so that the ends of the U point upward. The edge of the shield proper is pushed between the upward-pointing ends so that the ends exert a spring force on the shield and hold it in place.

Prior art arrangements based on soldering through the printed circuit board often have the disadvantage that holes in printed circuit boards use space in all layers of multi-layer printed circuit boards. Therefore it is desirable to have as few attachment pins as possible. On the other hand, if the attachment pins are wide apart, electromagnetic interference will leak through the gaps between the points of attachment of the EMC shield. A solution for this problem is known from patent document US 5 053 924, wherein springs are attached onto the edge of the cover in the areas between the attachment pins, such that the springs are pushed against a grounding strip on the surface of the printed circuit board. However. the manufacturing of the springs as separate mechanical components and their insertion comprise an extra step in a process in which the number of steps typically has a considerable effect on the costs.

An alternative method is to solder or glue an integral EMC shield by its edges to a printed circuit board. The disadvantage of this method is that it is very difficult to service the components under the EMC cover. Furthermore, solutions are known wherein a metal layer is vaporised on the inner surface of the outer shell of the apparatus or whole or part of the outer shell is made of metal and ridges on its inner surface touch directly or through conductive elastic material contact areas on the printed circuit board. This kind of an embodiment is inflexible as a change in the component layout or elsewhere requires that the whole outer shell structure be redesigned. Furthermore, it may be difficult to provide a reliable contact between the shield and the printed circuit board. In addition, EMC shields according to the prior art are hard to make so tight that they would also protect against moisture, dirt and dust.

An object of the present invention is to provide a protective device for an electrical apparatus, the construction of said device being selectable in the manufacturing stage so that it protects the electrical apparatus against moisture, dirt, dust, electromagnetic interference and/or unauthorised access. Another object of the invention is that the protective device according to it is cheap to manufacture and that its manufacture and connection to the electrical apparatus can be automated. A further object of the invention is that the protective device shall not limit the implementation of lead-ins, transparent areas and other communications paths. A yet further object of the invention is that the protective device according to it shall not take much space and shall not weigh a lot. Still another object of the invention is that the protective device according to it will eliminate the breakdown risk and capacitive coupling between the inner parts of the electrical apparatus and EMC shield.

The objects of the invention are achieved by a protective device made from a preformed film-like material which can be closed around a printed circuit board or corresponding component part. Preforming means that the film, which is the material of the protective device, sets relatively rigidly into a desired shape prior to the attachment to the printed circuit board or corresponding component part. In order to make handling and automation easier, the preforming and other preliminary steps are advantageously carried out using a rollable tape comprising several protective devices.

The protective device according to the invention as claimed comprises a preformed protective cover of a film-like material, said preforming conforming, where desired, to the topography of the component part to be protected and said cover being designed so as to envelope said component part substantially from all sides.

The invention as claimed is also directed to a method for manufacturing said protective cover. The method according to the invention is characterised in that at least two parts of a said film-like cover are preformed with a joining structure on the edge of at least one part and attached to each other in such a manner that the component part to be protected is enclosed within a closed structure.

The invention is based on the fact that the shape of the component part to be protected is well known in advance. Since most of the modem electronic devices are manufactured on automatic assembly lines where robots insert the components on the printed circuit boards with the accuracy of up to a hundredth of a millimetre, the printed circuit boards emerging from an assembly line are very much alike as far as their topography is concerned. The same applies to many other component parts to the protection of which the invention is applicable. A mould is made for the printed circuit board or corresponding component part to be protected, said mould being a model of the desired shape, imitating the topography of said printed circuit board or corresponding component part. When manufacturing the model, the empty space required around high-voltage and/or high-frequency components to prevent electrical breakdown and capacitive couplings can be taken into account as well as the tolerance which is generally needed around the components to allow for a slight inaccuracy in the insertion or mechanical manufacturing of components. According to the model a plastic protective cover is manufactured which may have a thickness of 0.01 to 1.5 millimetres and which exactly conforms to the topography of the object to be protected, however, taking into account said empty spaces and tolerances. In the preferred embodiment the protective cover comprises two parts. As printed circuit boards usually are planar, the two parts of the protective cover for protecting printed circuit boards comprise an upper half manufactured according to the upper surface of the printed circuit board and a lower half manufactured according to the lower surface of the printed circuit board. The words upper and lower refer to a certain perspective and do not limit the use of the invention in any particular direction. If the object to be protected is of another shape, the protective cover may comprise more parts. In some cases the protective cover may also comprise one part only.

The parts (in the case of a printed circuit board, the upper half and lower half) of a two- or multiple-part protective cover may in the manufacturing stage be entirely separate or they may be connected e.g. by a neck of material acting as a hinge, formed on a side of the cover. In the preferred embodiment, the edges of the parts of the protective cover will have on them joining structures that extend around the whole component part to be protected, said joining structures in the case of a printed circuit board preferably comprising an attachment groove along the edge of a first half and a corresponding attachment ridge along the edge of a second half. As the edges of the halves are pressed together the joining structures lock the halves to one another. If necessary, the joint can be secured by means of gluing, welding or another known method. The parts of the protective cover may also be glued or welded together by their edges without the help of a special joining structure, but the use of a joining structure may be more advantageous as far as the manufacturing process and reliability of the joint are concerned.

Since the manufacturing of the protective device according to the invention in any case requires that the shape and structure of the component part to be protected be known, also the holes possibly needed for connectors and other components can be taken into account. One of the two parts of a connector (usually, so-called female part) is found on the printed circuit board. The protective device according to the invention exactly follows the outer edge of the connector so that it can be easily attached to it by gluing or in another suitable manner so that a hole remains only where the contact surface of the connector is. Optical lead-ins, i.e. displays, LEDs and the like do not require any special holes or structures, if the protective device according to the invention is made of a transparent material such as a film of polyester, polyethylene, polypropylene or polycarbonate.

To provide EMC shielding, the parts of the protective cover can be coated by a metal layer or another conductive layer before it is attached to the object to be protected. The coating is preferably formed on the outer surface of the protective cover lest it come into contact with electrically conductive parts of the component part enclosed within the protective cover. However, coating produced by means of evaporation may be extended to desired parts of the inner surface of the cover if e.g. a contact with certain grounded parts of the printed circuit board is desired. As a metal layer produced by means of evaporation or in another manner usually does not let light pass through it, those areas of the protective cover that cover e.g. displays or LEDs are left uncoated. Areas of desired shape and size can be easily left uncoated by masking said areas prior to the coating. Metallisation can be carried out in several phases so that the individual layers are thinner and provide a better EMC shield than one thick layer. Other layers can be created between or over or beneath the metal layers. As the topmost metal layer, a thin layer is also aesthetically better-looking than a thick one if the material and manner of manufacture of the intermediate layer created under it are correctly chosen.

In the manufacturing stage where the parts of the protective cover are shaped according to the topography of the object to be protected, taking into account the desired additional spaces, other desired structures can be formed on said parts as well. For example, on a desired location of the protective cover it is possible to form a perforation comprising several adjacent holes or depressions, thus providing a tear line. If a completed protective cover closed over a component part is to be opened later, it can be easily torn open along the perforation, which has two advantages. First, the protective cover comes off easily and without damaging the components. Second. if protective covers of a certain design or marked with a certain security code are not generally available, an unauthorised person cannot open the protective cover and close it or insert the object in a new protective cover without leaving traces. An authorised dealer stocking the protective covers in question, however, can tear open the old protective cover, service the object and enclose it in a new protective cover.

In a preferred embodiment of the present invention protective covers are manufactured in a long tape which can be rolled up or folded into a stack. Manufacturing of the parts of the protective cover may start with a rolled-up tape of plastic film. The first step is to form the parts according to the desired topography. The second step comprises metallisation and other necessary surface treatment processes. In the third step the parts of the protective cover are cut out from the tape, installed around a printed circuit board or another object and closed mechanically, by means of gluing or by welding. The process may advance directly from step to step or it may be carried out even in three different places, in which case the parts of the protective cover are transferred from one place to another in the form of a tape which has been rolled up or folded into a stack. A long tape easily contains several hundred protective cover parts, thus eliminating the need for individual handling of protective devices. The installation of completed protective covers around printed circuit boards or other objects is preferably carried out in a "packaging" phase added to the end of the manufacturing line producing said covers, so that the shielding process shall not require individual handling of printed circuit boards either. This is a considerable improvement compared to the prior art, because the degree of automation can be increased from what it is currently.

The invention will now be described in more detail with reference to the preferred embodiments presented by way of example and to the accompanying drawings wherein
- Fig. 1: shows a printed circuit board protected by the protective device according to the invention,
- Fig. 2: shows parts of the protective device according to the invention during manufacturing,
- Fig. 3: shows by way of example different coating options, and
- Fig. 4: shows a cross section of a perforation formed on a protective device.

Like elements in the drawings are denoted by like reference designators.

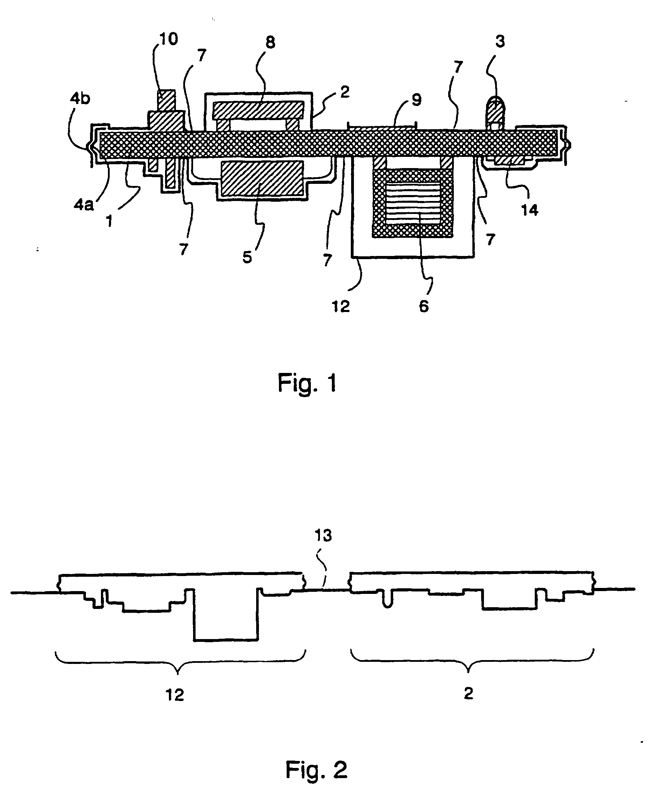

Fig. 1 is a cross sectional view of a printed circuit board shielded by the protective device according to the invention. The dimensions of the Figure are directive and chosen mainly on grounds of graphic clarity. On the surface (in this case, both the upper and lower surface) of a printed circuit board I there are inserted components such as a connector 10, microprocessor 8, light-emitting diode, or LED 3, resistor 14, small transformer 6 and a capacitor 5. These components impose their specific requirements on the shield. The connector 10 requires a hole in the shielding through which a counterpart (not shown) of the connector can be brought into contact with the contact surfaces of the connector 10. Inside the microprocessor 8 there travel several high-frequency signals carried by thin conductors so that an electrically conductive shield shall not touch the outer surface of the processor lest there occur capacitive coupling between said signals and said outer surface. At the light-emitting diode 3 the shield shall be transparent so that the LED can be observed from outside the shield. Some parts of the transformer 6 have high voltages which requires a certain minimum distance between the transformer and an electrically conductive protective cover in order to eliminate the risk of electrical breakdown. The resistor 14 sets few other requirements except that the protective cover shall conform to its rather minute topographic details so that the protective cover take as little space as possible. In addition, the shape of the protective cover has to be such that it leaves a space around the resistor in accordance with the statistical variation of the location of the resistor in an automatic insertion process. Depending on the construction of the circuit the capacitor 5 may have a risk of capacitive coupling and/or electrical breakdown.

The protective device according to the invention, which hereinafter will be called a protective cover, comprises an upper 2 and lower 12 half manufactured such that they conform to the topography of a printed circuit board. The upper half 2 conforms to the topography of the upper surface of the printed circuit board with its components. For the connector 10 the upper half of the protective cover has a hole shaped according to the outer edge of the connector such that the edge of said hole can be glued or otherwise attached to the edge of the connector or to the printed circuit board around the connector so that the hole will not constitute a point of leakage in the protective cover. At the microprocessor 8 the upper half of the protective cover is raised such that between said cover and microprocessor there is an air space that reduces capacitive coupling. At the light-emitting diode 3 the upper half of the protective cover is made locally transparent in a manner described later on. The lower half 12 of the protective cover conforms to the topography of the lower surface of the printed circuit board with its components so that, for example, an air space is left around the transformer 6 to prevent electrical breakdown.

Along the length of the edge of the lower half 12 of the protective cover there runs a joining ridge 4a which in the cross section depicted in Fig. I shows as an outward bend in the line representing the protective cover. Correspondingly, along the length of the edge of the upper half 2 there runs a joining groove 4b which can be seen as a similar bend in Fig. 1. The dimensions of the halves of the protective cover are identical to such an extent that when they are positioned around the printed circuit board as shown in Fig. 1 the joining groove 4b is pressed tightly against the joining ridge 4a on every side of the protective cover edge. Additionally, the joint can be secured by spreading glue in the joining groove 4b, applying welding along the edge, of the protective cover or by means of another known joining method for plastic parts. The shapes of the ridge 4a and groove 4b shown in Fig. 1 are exemplary only and on the basis of what is disclosed a person skilled in the art can easily come up with similar joining structures. If the halves of the protective cover are joined by their edges using glue, welding or another method, such joining structures are not necessarily needed. However, said structures help produce a secure joint and automatically align the halves of the protective cover.

Fig. 1 further shows on the upper surface of the printed circuit board 1 a connection area 9 which is not a connector proper but just a metallised area on the surface of the board. It is assumed that the printed circuit board is intended to be connected to a battery, reading device or another corresponding apparatus by means of slide contacts so that the flexible contact strips proper are in said apparatus (not shown). The protective cover naturally has to be open at that location for the connection area 9 to fulfil its purpose. To make sure the protective cover is tight, the upper half 2, which has a hole for the connection area 9, can be glued or taped to the printed circuit board at the edges of the connection area 9 and/or it may have a joining structure around the connection area, intended to be pressed against a matching structure on the battery, reading device or another corresponding apparatus, thereby forming a secure joint. It is also possible to permanently attach to the connection area a cooling plate or another device for conducting heat out of the protective cover.

Transfer of signals between the printed circuit board and another device does not necessarily require a hole in the protective cover if the frequency of the transferred signal is high enough. The printed circuit board may have a metallised area at which the protective cover is even and touches the surface of the metallised area. An external apparatus has a corresponding flat metallised area which, when the printed circuit board and the external apparatus are being connected, is pressed against the surface of the protective cover at the metallised area on the printed circuit board. The facing surfaces on the printed circuit board and external apparatus constitute a capacitive feed-through which appears as a short circuit to a signal with a frequency high enough. The metallisation of the protective cover must not be grounded at that location lest it prevent the operation of the capacitive feed-through. On the other hand, a metallised patch on the protective cover the size of which matches the capacitive feed-through and which is surrounded by an insulating rim, may even enhance the operation of the capacitive feed-through.

Fig. 2 is a diagrammatic side view of the two parts of the protective device according to the embodiment described above, shown before attachment to a printed circuit board or another component part to be protected. The first part 12 corresponds to the lower half of the protective cover of the embodiment depicted in Fig. 1 and the second part 2 corresponds to the upper half of the protective cover of the embodiment depicted in Fig. 1. At this stage of manufacture the parts are connected by a neck 13 which may be of the same material as the parts themselves or made of a special-purpose tape, film or other material. The invention does not limit the manufacturing method of the parts of the protective device, but in a preferred embodiment they are preformed from a long, tape-like piece of raw material by means of deep drawing, blowing, pressing, rolling or using some other known technique. Then all parts of the protective device made from the same tape in succession are connected to each other by a neck 13 according to Fig. 2 after the preforming. The tape comprising the preformed parts may be fed as such directly to the next manufacturing stage or it may be rolled up or folded into a stack so that its transportation and storage are easier than if the corresponding number of protective device parts were handled as separate pieces. Before the protective device is attached to the component part to be protected, its parts can be cut off by laser, cutting blade or another means. Parts belonging to one and the same protective cover may be left partly joined so that the neck between them forms a hinge.

In some embodiments it is possible to control, with great precision, the thickness of the different parts of the film. This can be utilised in the preforming stage by making certain locations, where transparency is desired, lens-like in form so that they direct beams of light in the desired manner.

Materials suitable for the tape-based manufacturing method described above include several widely used plastic films such as those made of polycarbonate, polyethylene, polypropylene and polyester, for instance. On the one hand, the thickness of the plastic film is limited by the fact that it must be durable and rigid enough, and on the other hand that it must not be too thick lest it take too much space and is difficult to handle. A suitable thickness is usually from 0.01 to 1.5 millimetres. Sufficient rigidity means that when empty space is left around components, e.g. to reduce the risk of electrical breakdown, the film must not collapse at these locations but it must retain its shape in normal operating and storage conditions. On the other hand, in applications where there are push buttons implemented using the membrane technology or other touch-sensitive parts on the surface of the printed circuit board, the part of the protective cover that covers them must not be so rigid that the use of the push buttons is substantially hampered but said part of the protective cover is flexible so as to allow the touch-sensitive parts to be used. Sufficient durability means that normal handling during manufacturing must not cause unwanted holes or tears in the film.

To realise EMC shielding, the protective device according to the invention comprises a substantially continuous, electrically conductive layer. Since the electrically conductive layer is usually metallic, it will be hereinafter called metal plating. "Substantially continuous" means that the metal plating may have intentional gaps where the protective device has to be transparent or where a capacitive feed-through is desired. To be substantially continuous the metal plating need not form a solid surface but it may be e.g. mesh-like if such a construction provides sufficient attenuation of electromagnetic radiation. At locations where transparency is desired transparent protective coating methods known from the prior art can be applied (cf. US 5 147 694, for example). If the light-emitting diode in Fig. I is already EMC shielded, no separate EMC shielding is needed at its location. Then the protective cover may have a hole the edges of which are securely joined to the edges of the LED, or the top of the dome in the protective cover may be unplated (=transparent), said dome fitting so tightly around the LED that the tight fitting prevents EMC leakage at the edges of the diode.

As a rule, the metal plating of the protective cover shielding a printed circuit board is created on the outer surface of the cover. A preferred metallisation method is vacuum evaporation, but other methods can be used as well. The metal used is usually aluminium, gold, silver or a metal alloy and the thickness of the plating depends on the desired level of shielding and on the metallisation method. A 4-µm layer often produces satisfactory EMC shielding. Locations where metal plating is not needed can be masked prior to the vacuum evaporation. Locations on the inner surface of the cover can be metallised as well. Reference designator 7 in Fig. 1 represents several spots where a component has been especially shielded by surrounding it with a grounded strip or area. The protective cover has a corresponding metallised area on the inner surface that touches the metal plating on the surface of the printed circuit board. This way two metallised areas on the surface of the printed circuit board can be connected by arranging the connection between them via the inner surface of the protective cover.

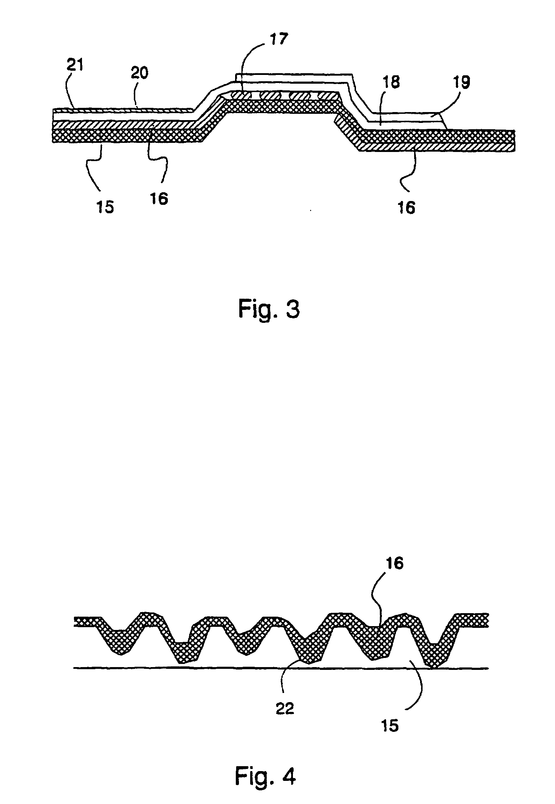

The metal plating need not be the outermost layer in the protective device according to the invention but patterns or layers may be formed over the plating by means of vaporising, varnishing, pressing or another method. The outer layers may be continuous or they may have gaps. The metal plating may also comprise multiple layers because in certain situations thin layers on top of each other shield, against electromagnetic radiation more effectively than one thick layer. Intermediate layers made of other materials may be formed between the layers. To create a fine glossy surface on the protective device by vacuum evaporation the surface must have a very even intermediate layer and on top of that a metal plating having a thickness of 1 µm at the most. Using methods which are known per se a hologram or another hard-to-duplicate printed pattern may be formed on the topmost or intermediate layer so as to verify that the product is original. Fig. 3 shows some exemplary coating options, reference designator 15 representing a plastic film serving as a substrate, reference designator 16 representing a continuous or patterned metal plating on the surface (upper or lower surface) of said film, reference designator 17 representing a mesh-like metal plating, reference designator 18 representing an insulative intermediate layer, reference designator 19 representing a transparent anti-oxidisation and anti-wear surface layer, which may be made of polytetrafluoroethylene (PTFE), for example, (such as Teflon, a registered trademark of DuPont) or another known material known in the field of coating, reference designator 20 representing a thin metal plating formed on the surface, and reference designator 21 representing a hologram formed on the metal plating by laser. Various patterns and gaps are possible in all layers, thereby also producing desired electrically conductive or other connections between layers.

Fig. 4 is an enlarged cross sectional view of a detail of the protective device according to the invention where a row of holes or depressions 22 have been formed in the plastic film 15 by pressing, laser or using another method. The metal plating 16 may extend continuously over the holes or depressions, thus sealing against possible undesired leaks in the protective cover. The strength of the plastic film 15 along the row of holes or depressions is substantially weaker than in other directions, so it can be easily torn across along the row of holes or depressions. Such a perforation can be formed in almost any location of the protective device according to the invention so that the protective cover can be easily opened by tearing it open along the perforation. The tearing open of the perforation is an irreversible step, so the state of the perforation indicates whether the protective cover has been opened or not. The warranty of the apparatus may include a clause stating the warranty is invalid if the perforation has been torn open and the protective cover opened by some-one other than an authorised service representative.

In the description above the component part to be protected was primarily a printed circuit board but it is obvious to one skilled in the art that the protective device according to the invention can be used to shield almost any relatively small object the shape of which is known. "Relatively small" means that the dimensions of the component part to be protected are not so great that the manufacturing of the protective cover for it would require equipment bigger than the usual machine size in the field of packaging. The component part need not be substantially planar like a printed circuit board but even complex three-dimensional shapes can be shielded by manufacturing the protective cover such that is comprises more than two parts. If the part the be protected is permanently attached by one of its sides to a fixed surface the invention can be applied by manufacturing a single-part protective cover that covers the part to be protected and is attached around said part by its edges to said fixed surface by means of a joining structure and/or glue, welding or another method.

A plain plastic protective cover closed by means of a simple mechanical joining structure is sufficient for protecting the enclosed component part against dirt and dust. If the joint between the parts of the protective cover is tight enough, the plastic protective cover will shield against moisture, too. A metal plating is applied when EMC shielding is required. Thus, the protective device according to the invention can be flexibly adapted to the level of shielding required. A manufacturing method in which the parts of the protective device constitute a long tape during the whole manufacturing process is particularly advantageous from the automation standpoint. Detachment of the protective device from the tape and its attachment over the component part to be protected can also be automated as this manufacturing stage corresponds to packaging and from the prior art it is known several automatic packaging machines. Lead-ins and transparent windows can be freely formed on the protective device according to the invention, so it will not limit the realisation of communications paths. As the protective device according to the invention is thin and exactly conforms to the shapes of the component part to be protected it will not take much space and not weigh a lot. The protective device can be preformed so as to leave a desired space around the components enclosed within the shielding, which prevents undesired capacitive couplings and electrical breakdowns. Consequently, it can be said that the objects of the invention are thus achieved.

## Claims

1. A protective device for shielding an electrical component part (1) during its operation, comprising a protective cover (2, 12) preformed of a film-like material, the preforming conforming to the topography of said component part in predetermined respects, comprising:
- at least two parts (2, 12) designed to be attached to each other in such a manner that the component part (1) to be protected is enclosed within a closed structure,
**characterised in that** it further comprises:
- a joining structure (4a, 4b) on the edge of at least one part for mechanically attaching the parts to one another.

2. The protective device of claim 1, **characterised in that** it comprises between at least two parts a hinge portion (13) to join said parts to each other in a turning manner.

3. The protective device of claim 1 or 2, **characterised in that** said parts are designed to be attached to one another in such a manner that the joint between them is watertight.

4. The protective device of claim 3, **characterised in that** in order to increase the tightness said joint comprises a reinforcement which is one of the following: welding, gluing, taping.

5. The protective device or claim 1, 2 or 3, **characterised in that** said parts are arranged to be attached to one another with a re-openable mechanical joint.

6. The protective device of any one of the preceding claims, **characterised in that** it comprises a physical gap to enable a contact between a connector element (10) in the component part to be protected and another component part, the edge of said gap being designed so as to be sealed around said connector element (10).

7. The protective device of any one of the preceding claims, **characterised in that** it comprises a portion which, in order to leave an insulative gas space of a predetermined size between the component part to be protected and the protective device, is raised with respect to the local topography (8, 13) of said component part.

8. The protective device of any one of the preceding claims, **characterised in that** it is manufactured of one of the following materials: polyester, polyethylene, polycarbonate, polypropylene.

9. The protective device of any one of the preceding claims, **characterised in that** it further comprises a substantially continuous electrically conductive layer (16) in order to provide EMC shielding for said component part.

10. The protective device of claim 9, **characterised in that** said electrically conductive layer is metallic.

11. The protective device of claim 9, **characterised in that** said electrically conductive layer is made of a conductive polymer.

12. The protective device of claim 9, 10 or 11, **characterised in that** said electrically conductive layer comprises a gap in order to create a visual connection between the component part (3) to be protected and its environment.

13. The protective device of any one of claims 9 to 12, **characterised in that** said electrically conductive layer is on that side of said film-like material which is not intended against the component part to be protected and that it further comprises at least one electrically conductive area on the other side of said film-like material.

14. The protective device of any one of claims 9 to 13, **characterised in that** said electrically conductive layer comprises at least two sublayers.

15. The protective device of any one of claims 9 to 14, **characterised in that** it comprises on at least part of its outer surface a metal layer (20) no more than 1 µm thick in order to create a glossy outer surface.

16. The protective device of any one of the preceding claims, **characterised in that** it comprises a proof of genuineness (21).

17. The protective device of any one of the preceding claims, **characterised in that** it further comprises on its outermost surface a substantially continuous anti-oxidisation and anti-wear layer (19).

18. The protective device of any one of the preceding claims, **characterised in that** it comprises a row of holes or depressions (22) to form a tear line.

19. The protective device of claim 18, **characterised in that** said holes or depressions are in said film-like material (15) so that coatings (16) formed on its surface cover and seal said holes or depressions.

20. A method for producing a protective device for shielding an electrical component part during its operation, comprising a step of preforming a cover consisting of film-like material to conform to the topography of said component part in predetermined respects before being attached to said electrical component part **characterised in that** at least two parts (2, 12) of said film-like cover are preformed with a joining structure (4a, 4b) on the edge of at least one part, and attached to each other in such a manner that the component part (1) to be protected is enclosed within a closed structure.

21. The method of claim 20, **characterised in that** several successive parts (2, 12) of the protective device are preformed of a tape-like material in such a manner that said parts form a tape also after the preforming.

22. The method of claim 21, **characterised in that** said protective devices are formed by a method that is one of the following: deep drawing, blowing, pressing, rolling.

23. The method of any one of claims 20 to 22, **characterised in that** after the preforming it comprises at least one coating step in which a coating (16) of a desired shape is formed on the surface of the protective device without detaching the protective device from the tape of successive protective devices.

24. The method of claim 23, **characterised in that** said coating step is vacuum evaporation.

25. The method of claim 23 or 24, **characterised in that** in said coating step at least one part of a desired shape of said protective device is left uncoated.

## Patentansprüche

1. Eine Schutzvorrichtung zum Abschirmen eines elektrischen Bauteils (1) während seines Betriebs, welche eine Schutzabdeckung (2, 12) umfasst, die aus einem folienähnlichen Material vorgeformt ist, wobei das Vorgeformte mit der Topografie des Bauteils in bestimmter Hinsicht übereinstimmt, umfassend:
- mindestens zwei Teile (2, 12), welche ausgebildet sind, um derart aneinander befestigt zu werden, dass das zu schützende Bauteil (1) innerhalb einer geschlossenen Struktur eingeschlossen ist,
**dadurch gekennzeichnet, dass** sie des weiteren umfasst:
- eine Verbindungsstruktur (4a, 4b) an der Kante mindestens eines Teils, um die Teile mechanisch aneinander zu befestigen.

2. Die Schutzvorrichtung nach Anspruch 1, **dadurch gekennzeichnet, dass** sie zwischen mindestens zwei Teilen ein Gelenkstück (13) umfasst, um die Teile in drehender Weise miteinander zu verbinden.

3. Die Schutzvorrichtung nach Anspruch 1 oder 2, **dadurch gekennzeichnet, dass** die Teile ausgebildet sind, um derart aneinander befestigt zu werden, dass die Verbindung zwischen ihnen wasserdicht ist.

4. Die Schutzvorrichtung nach Anspruch 3, **dadurch gekennzeichnet, dass**, um die Dichtigkeit zu erhöhen, die Verbindung eine Verstärkung umfasst, welche eine der folgenden ist: Schweißverbindung, Klebverbindung, Tapeverbindung.

5. Die Schutzvorrichtung nach Anspruch 1, 2 oder 3, **dadurch gekennzeichnet, dass** die Teile angeordnet sind, um mit einer wieder zu öffnenden mechanischen Verbindung aneinander befestigt zu werden.

6. Die Schutzvorrichtung nach einem der vorhergehenden Ansprüche, **dadurch gekennzeichnet, dass** sie einen physikalischen Spalt umfasst, um einen Kontakt zwischen einem Anschlusselement (10) in dem zu schützenden Bauteil und einem anderen Bauteil zu ermöglichen, wobei die Kante dieses Spalts ausgebildet ist, um rund um das Anschlusselement (10) abgedichtet zu sein.

7. Die Schutzvorrichtung nach einem der vorhergehenden Ansprüche, **dadurch gekennzeichnet, dass** sie einen Teil umfasst, welcher, um einen isolierenden Gasraum einer bestimmten Größe zwischen dem zu schützenden Bauteil und der Schutzvorrichtung zu lassen, In Bezug auf die lokale Topografie (8, 13) des Bauteils erhöht ist.

8. Die Schutzvorrichtung nach einem der vorhergehenden Ansprüche, **dadurch gekennzeichnet, dass** sie aus einem der folgenden Materialien hergestellt ist: polyester, Polyethylen, Polycarbonat, Polypropylen.

9. Die Schutzvorrichtung nach einem der vorhergehenden Ansprüche, **dadurch gekennzeichnet, dass** sie des weiteren eine im wesentlichen kontinuierliche elektrisch leitende Schicht (16) umfasst, um eine EMC Abschirmung für das Bauteil zur Verfügung zu stellen.

10. Die Schutzvorrichtung nach Anspruch 9, **dadurch gekennzeichnet, dass** die elektrisch leitende Schicht metallisch ist.

11. Die Schutzvorrichtung nach Anspruch 9, **dadurch gekennzeichnet, dass** die elektrisch leitende Schicht aus einem leitenden Polymer hergestellt ist.

12. Die Schutzvorrichtung nach Anspruch 9, 10 oder 11, **dadurch gekennzeichnet, dass** die elektrisch leitende Schicht einen Spalt umfasst, um einen sichtbaren Anschluss zwischen dem zu schützenden Bauteil (3) und seiner Umgebung zu bilden.

13. Die Schutzvorrichtung nach einem der Ansprüche 9 bis 12, **dadurch gekennzeichnet, dass** die elektrisch leitende Schicht auf der Seite des folienähnlichen Materials ist, welche nicht an dem zu schützenden Bauteil vorgesehen ist, und dass sie des weiteren mindestens einen elektrisch leitenden Bereich auf der anderen Seite des folienähnlichen Bereichs umfasst.

14. Die Schutzvorrichtung nach einem der Ansprüche 9 bis 13, **dadurch gekennzeichnet, dass** die elektrisch leitende Schicht mindestens zwei Teilschichten umfasst.

15. Die Schutzvorrichtung nach einem der Ansprüche 9 bis 14, **dadurch gekennzeichnet, dass** sie auf zumindest einem Teil ihrer Außenfläche eine nicht mehr als 1 µm dicke Metallschicht (20) umfasst, um eine glänzende Außenfläche zu bilden.

16. Die Schutzvorrichtung nach einem der vorhergehenden Ansprüche, **dadurch gekennzeichnet, dass** sie einen Echtheitsnachweis (21) umfasst.

17. Die Schutzvorrichtung nach einem der vorhergehenden Ansprüche, **dadurch gekennzeichnet, dass** sie auf ihrer äußersten Fläche des weiteren eine im wesentlichen kontinuierliche Antioxidationsund Antiverschleissschicht (19) umfasst.

18. Die Schutzvorrichtung nach einem der vorhergehenden Ansprüche, **dadurch gekennzeichnet, dass** sie eine Reihe Löcher oder Vertiefungen (22) umfasst, um eine Reißlinie zu formen.

19. Die Schutzvorrichtung nach Anspruch 18. **dadurch gekennzeichnet, dass** die Löcher oder Vertiefungen in dem folienähnlichen Material (15) sind, so dass auf ihrer Oberfläche geformte Schichten (16) die Löcher und Vertiefungen abdecken und abdichten.

20. Ein Verfahren zum Herstellen einer Schutzvorrichtung zum Abschirmen eines elektrischen Bauteils während seines Betriebs, umfassend einen Schritt des Vorformens einer Abdeckung, welche aus folienähnlichern Material besteht, um mit der Topografie des Bauteils in bestimmter Hinsicht übereinzustimmen, bevor sie an dem elektrischen Bauteil befestigt wird, **dadurch gekennzeichnet, dass** mindestens zwei Teile (2, 12) der folienähnlichen Abdeckung vorgeformt sind, mit einer Verbindungsstruktur (4a, 4b) auf der Kante mindestens eines Teils, und derart aneinander befestigt sind, dass das zu schützende Bauteil (1) innerhalb einer geschlossenen Struktur eingeschlossen wird.

21. Das Verfahren nach Anspruch 20, **dadurch gekennzeichnet, dass** mehrere aufeinander folgende Teile (2, 12) der Schutzvorrichtung aus einem streifenähnlichen Material derart vorgeformt sind, dass diese Teile auch nach dem Vorformen einen Streifen bilden.

22. Das Verfahren nach Anspruch 21, **dadurch gekennzeichnet, dass** die Schutzvorrichtungen durch ein Verfahren hergestellt werden, das eines der folgenden ist: Tiefziehen, Blasen, Pressen, Walzen.

23. Das Verfahren nach einem der Ansprüche 20 bis 22, **dadurch gekennzeichnet, dass** es nach dem Vorformen mindestens einen Beschichtungsschritt umfasst, in welchem eine Schicht (16) gewünschter Form auf der Oberfläche der Schutzvorrichtung, ohne Ablösen der Schutzvorrichtung von dem Streifen aufeinander folgender Schutzvorrichtungen, geformt wird.

24. Das Verfahren nach Anspruch 23, **dadurch gekennzeichnet, dass** der Beschichtungsschritt Vakuumbedampfung ist.

25. Das Verfahren nach Anspruch 23 oder 24, **dadurch gekennzeichnet, dass** in dem Beschichtungsschritt mindestens ein Teil einer gewünschten Form der Schutzvorrichtung unbeschichtet bleibt.

## Revendications

1. Dispositif de protection permettant de blinder une partie de composant électrique (1) pendant son fonctionnement, comprenant un capot protecteur (2, 12) préformé sur un matériau en couche, le préformage se conformant à la topographie de ladite partie de composant dans des aspects prédéterminés, comprenant :
- au moins deux parties (2, 12) conçues pour être fixées l'une à l'autre d'une manière telle que la partie de composant (1) à protéger est enfermée à l'intérieur d'une structure fermée,
**caractérisé en ce qu'**il comprend en outre :
- une structure de jonction (4a, 4b) sur le bord d'au moins une partie pour fixer mécaniquement les parties les unes aux autres.

2. Dispositif de protection selon la revendication 1, **caractérisé en ce qu'**il comprend entre au moins deux parties une partie de charnière (13) pour relier lesdites parties les unes aux autres d'une manière tournante.

3. Dispositif de protection selon la revendication 1 ou 2, **caractérisé en ce que** lesdites parties sont conçues pour être fixées les unes aux autres d'une manière telle que le joint entre elles est étanche à l'eau.

4. Dispositif de protection selon la revendication 3, **caractérisé en ce que**, afin d'augmenter l'étanchéité, ledit joint comprend un renforcement qui est l'un de ce qui suit : soudage, collage, rubanage.

5. Dispositif de protection selon la revendication 1, 2 ou 3, **caractérisé en ce que** lesdites parties sont agencées pour être fixées les unes aux autres avec un joint mécanique que l'on peut rouvrir.

6. Dispositif de protection selon l'une quelconque des revendications précédentes, **caractérisé en ce qu'**il comprend un écart physique pour permettre un contact entre un élément de connexion (10) dans la partie de composant à protéger et une autre partie de composant, le bord dudit écart étant conçu de façon à être scellé autour dudit élément de connexion (10).

7. Dispositif de protection selon l'une quelconque des revendications précédentes, **caractérisé en ce qu'**il comprend une partie qui, afin de laisser un espace de gaz isolant d'une taille prédéterminée entre la partie de composant à protéger et le dispositif de protection, est relevée par rapport à la topographie locale (8, 13) de ladite partie de composant.

8. Dispositif de protection selon l'une quelconque des revendications précédentes, **caractérisé en ce qu'**il est fabriqué à partir de l'un des matériaux suivants : polyester, polyéthylène, polycarbonate et polypropylène.

9. Dispositif de protection selon l'une quelconque des revendications précédentes, **caractérisé en ce qu'**il comprend en outre une couche conductrice sensiblement électriquement continue (16) afin de fournir un blindage de compatibilité électromagnétique pour ladite partie de composant.

10. Dispositif de protection selon la revendication 9, **caractérisé en ce que** ladite couche conductrice électriquement est métallique.

11. Dispositif de protection selon la revendication 9, **caractérisé en ce que** ladite couche conductrice électriquement est faite à partir d'un polymère conducteur.

12. Dispositif de protection selon la revendication 9, 10 ou 11, **caractérisé en ce que** ladite couche conductrice électriquement comprend un écart afin de créer une connexion visuelle entre la partie de composant (3) à protéger et son environnement.

13. Dispositif de protection selon l'une quelconque des revendications 9 à 12, **caractérisé en ce que** ladite couche conductrice électriquement est sur ce côté dudit matériau en couche qui ne doit pas être contre la partie de composant à protéger et **en ce qu'**il comprend en outre au moins une zone conductrice électriquement de l'autre côté dudit matériau en couche.

14. Dispositif de protection selon l'une quelconque des revendications 9 à 13, **caractérisé en ce que** ladite couche conductrice électriquement comprend au moins deux sous-couches.

15. Dispositif de protection selon l'une quelconque des revendications 9 à 14, **caractérisé en ce qu'**il comprend sur au moins une partie de sa surface extérieure, une couche métallique (20) de pas plus de 1 µm d'épaisseur afin de créer une surface extérieure brillante.

16. Dispositif de protection selon l'une quelconque des revendications précédentes, **caractérisé en ce qu'**il comprend une preuve d'authenticité (21).

17. Dispositif de protection selon l'une quelconque des revendications précédentes, **caractérisé en ce qu'**il comprend en outre sur sa surface la plus extérieure, une couche antioxydante et anti-usure sensiblement continue (19).

18. Dispositif de protection selon l'une quelconque des revendications précédentes, **caractérisé en ce qu'**il comprend une rangée d'orifices ou de creux (22) pour former une ligne de pointillés.

19. Dispositif de protection selon la revendication 18, **caractérisé en ce que** lesdits orifices ou creux sont dans ledit matériau en couche (15) pour que les revêtements (16) formés sur sa surface recouvrent et scellent lesdits orifices ou creux.

20. Procédé pour produire un dispositif de protection permettant le blindage d'une partie de composant électrique pendant son fonctionnement, comprenant une étape de préformage d'un capot comprenant un matériau en couche pour se conformer à la topographie de ladite partie de composant dans des aspects prédéterminés avant d'être fixé à ladite partie de composant électrique **caractérisé en ce qu'**au moins deux parties (2, 12) de ce que l'on appelle un capot en couche sont préformées avec une structure de jonction (4a, 4b) sur le bord d'au moins une partie, et fixées l'une à l'autre d'une manière telle que la partie de composant (1) à protéger est enfermée à l'intérieur d'une structure fermée.

21. Procédé selon la revendication 20, **caractérisé en ce que** plusieurs parties successives (2, 12) du dispositif de protection sont préformées à partir d'un matériau en couche d'une manière telle que lesdites parties forment un ruban également après le préformage.

22. Procédé selon la revendication 21, **caractérisé en ce que** lesdits dispositifs de protection sont formés par un procédé qui est l'un de ceux qui suivent : emboutissage profond, soufflage, pressage, roulement.

23. Procédé selon l'une quelconque des revendications 20 à 22, **caractérisé en ce qu'**après le préformage, il comprend au moins une étape d'enduction dans laquelle un revêtement (16) de forme souhaitée est formée sur la surface du dispositif de protection sans détacher le dispositif de protection du ruban des dispositifs de protection successifs.

24. Procédé selon 1a revendication 23, **caractérisé en ce que** ladite étape d'enduction est l'évaporation sous vide.

25. Procédé selon la revendication 23 ou 24, **caractérisé en ce que** dans ladite étape d'enduction au moins une partie de forme souhaitée dudit dispositif de protection est laissée non enduite.
